# FASCICULE DE BREVET EUROPEEN

(11) **EP 2 599 085 B1**
(45) Date de publication et mention de la délivrance du brevet: **26.04.2017**
(21) Numéro de dépôt: 11749248.8
(22) Date de dépôt: 21.07.2011
(51) Int. Cl.: G11C 11/16

(54) **ELEMENT DE MEMOIRE MAGNETIQUE**
MAGNETISCHES SPEICHERELEMENT
MAGNETIC MEMORY ELEMENT

(30) Priorité: 26.07.2010 FR 1003123
(43) Date de publication de la demande: 05.06.2013
(73) Titulaire: Centre National de la Recherche Scientifique, 75016 Paris (FR); Commissariat à l'Énergie Atomique et aux Énergies Alternatives, 75015 Paris (FR); Université Grenoble Alpes, 38400 Saint-Martin-d'Hères (FR); Institut Català De Nanotecnologia (ICN), 08193 Bellaterra (ES); Institució Catalana de Recerca i Estudis Avançats, 08010 Barcelona (ES)
(72) Inventeur: GAUDIN, Gilles, Louis, F-38700 Le Sappey (FR); MIRON, Ioan Mihai, E-08301 Mataro (ES); GAMBARDELLA, Pietro, E-08197 Sant Cugat Del Valles (ES); SCHUHL, Alain, F-38000 Grenoble (FR)
(74) Mandataire: Gevers & Orès
(86) Numéro de dépôt international: PCT/IB2011/053258
(87) Numéro de publication internationale: WO 2012/014131

(56) Documents cités:
- US-A1- 2007 109 853
- US-B1- 6 269 018

## Description

La présente invention a pour objet un élément de mémoire magnétique du type à retournement induit par un courant.

Le retournement de l'aimantation d'une couche ou d'un petit élément magnétique se fait communément au moyen d'un champ magnétique appliqué. La direction de celui-ci est changée suivant que l'on veuille retourner l'aimantation dans un sens ou dans un autre. C'est ce principe qui est à la base de l'écriture dans des pistes magnétiques ou des disques durs d'ordinateur : l'élément à retourner est mécaniquement placé au voisinage du générateur de champ magnétique de façon à localiser spatialement ce champ. C'est en effet la structure même du champ magnétique, par définition non localisé dans l'espace, qui soulève de nombreuses difficultés pour son intégration dans des dispositifs. Ainsi, lorsque aucune actuation mécanique n'est possible ou désirée, par exemple dans le cas des mémoires magnétiques solides de type "MRAM" (magnetic random access memories) ou des dispositifs logiques, il faut localiser suffisamment le champ magnétique pour que celui-ci n'agisse que sur la cellule cible sans impacter ses voisines. Ce problème devient de plus en plus important lorsque les différentes cellules mémoire ou logiques sont disposées très proches les unes des autres afin d'augmenter les densités.

La possibilité de manipuler l'aimantation au moyen d'un courant polarisé en spin qui a été démontrée tout d'abord théoriquement en 1996 a apporté une première solution à ce problème. Ce principe physique, appelé couple de transfert de spin (STT pour spin transfer torque en anglais) nécessite la présence, pour manipuler l'aimantation au niveau du point mémoire, d'au moins deux couches magnétiques séparées par un métal non magnétique (pour une structure de type vanne de spin) ou par un isolant (pour une structure de type jonction tunnel magnétique), les deux couches ayant leur aimantations non colinéraires. L'explication physique détaillée diffère suivant que l'on est en présence d'une structure vanne de spin ou jonction tunnel magnétique mais globalement le courant se polarise en spin à la traversée de la première couche magnétique, pour ensuite exercer un couple sur l'aimantation de la seconde couche au moyen de la composante non colinéaire de la polarisation du courant. Lorsque les densités de courant sont suffisantes, l'aimantation de la seconde couche magnétique peut être retournée à la fois pour les vannes de spin et les jonctions tunnel magnétiques.

Comme décrit par exemple dans le Brevet US 7 009 877 publié le 7 Mars 2006 et dans la Demande US 2009/129143 publiée le 21 Mai 2009, le courant électrique d'écriture traverse nécessairement la jonction perpendiculairement au plan des couches.

C'est également le cas du Brevet US 6,269,018 dans lequel (figure 5b) le courant d'écriture qui génère également un champ magnétique dans une couche centrale ferromagnétique traverse perpendiculairement au plan des couches un empilement de type jonction tunnel magnétique. On notera également que ce document met en oeuvre deux couches magnétiques distinctes.

Cette possibilité de manipuler localement l'aimantation d'un élément magnétique de taille sub-micronique au moyen d'un courant électrique a tout de suite généré des possibilités d'application. De nos jours, c'est l'intégration de ce principe dans les nouvelles architectures de cellules mémoire MRAM et des composants logiques qui est recherchée par les acteurs industriels.

Cette intégration se heurte pour l'instant à différentes difficultés qui semblent entrelacées.

Le retournement par STT nécessite la présence au niveau du point mémoire d'au moins deux couches magnétiques séparées par un espaceur non magnétique. L'écriture se fait comme indiqué ci-dessus en injectant un courant de forte densité à travers tout l'empilement perpendiculairement au plan des couches magnétiques, tandis que la lecture se fait au moyen de la magnétorésistance de l'empilement : magnétorésistance géante (GMR) pour les vannes de spin, et magnétorésistance tunnel (TMR) pour les jonctions tunnel magnétiques. De nos jours, toutes les applications ou presque sont basées sur l'utilisation de jonctions tunnel magnétiques. Ainsi, si le signal GMR n'est que de quelques pourcents, le signal TMR de jonctions à base de MgO est communément supérieur à 100%. Les jonctions tunnel ont néanmoins le désavantage de présenter des valeurs du produit résistance * surface (RA) importantes. Ainsi, pour une densité de courant typique de 10⁷ A/cm² nécessaire au retournement par STT, la tension aux bords de la jonction est de 10V pour un RA de 100Ω.µm², 1V pour un RA de 10 Ω.µm² et 0.1V pour un RA de 1 Ω.µm². Hormis pour la valeur la plus faible, la puissance dissipée dans la jonction est alors importante ce qui est préjudiciable à la fois en terme de consommation énergétique et d'endommagement de la dite jonction.

De plus, les valeurs importantes de TMR utiles à la lecture sont souvent obtenues pour des empilements présentant des valeurs de RA importantes.

Cela explique les recherches actuelles pour obtenir des jonctions tunnel présentant de fortes valeurs de TMR et de faibles valeurs de RA. De plus, même pour des valeurs relativement faibles de tension aux bords de la jonction, des phénomènes de vieillissement accéléré de la jonction dus aux cycles en tension ont été observés en fonctionnement. De nombreuses études sont consacrées actuellement à ce point à la fois pour optimiser les matériaux dans les géométries existantes mais aussi pour définir de nouvelles géométries pour découpler autant que possible les phénomènes d'écriture et de lecture.

En résumé, une difficulté réside dans l'impossibilité d'optimiser indépendamment la lecture et l'écriture car, dans les dispositifs à transfert de spin (STT) connus, les deux phénomènes sont intrinsèquement liés.

Une autre difficulté est liée au fait que l'écriture nécessite de faire passer un courant de très forte densité à travers l'empilement.

Une autre difficulté inhérente encore à ce lien provient de la complexité toujours plus grande des empilements. Ainsi, si l'on veut que l'effet de transfert de spin (STT) ne se fasse ressentir que dans la couche à retourner pour stocker l'aimantation, il faut par exemple stabiliser les autres couches au moyen d'un couplage d'échange avec un matériau antiferromagnétique ; si l'on veut augmenter l'amplitude du transfert STT, il faut optimiser les couches polarisantes ; si l'on veut diminuer les champs magnétiques rayonnés sur les couches sensibles, il faut utiliser par exemple des bicouche antiferromagnétiques artificielles ; etc...

Il en résulte que les empilements magnétiques typiques de cellules MRAM ou composants logiques peuvent comporter plus de 10 ou 15 couches différentes de matériaux divers. Ceci pose ensuite des difficultés dans les étapes de structuration et notamment dans l'étape de gravure qui est un des points de blocage les plus importants pour l'intégration de ces empilements magnétiques.

Une autre voie de recherche est de manipuler l'aimantation au moyen d'un champ électrique extérieur. Ceci peut être partiellement accompli en modifiant l'anisotropie d'un matériau au moyen d'un champ électrique extérieur, le retournement de l'aimantation s'effectuant au moyen d'un champ magnétique appliqué. Une telle technique est décrite dans l'article de T. MARUYAMA et collaborateurs intitulé « Large voltage-induced magnetic anisotropy charge in a few atomic layers of iron » (Nature Nanotechnology, vol. 4, March 2009 - Macmillan Publishers Ltd.).

Cette technique ne permet actuellement que de réduire l'anisotropie magnétique du matériau. Les processus d'écriture et de lecture sont alors les mêmes que ceux décrits ci-dessus, ainsi que leurs inconvénients.

La présente invention a pour objet un élément de mémoire magnétique qui, pour inverser l'aimantation, ne nécessite la présence que d'une couche magnétique (ayant une aimantation parallèle ou perpendiculaire à son plan) et qui fonctionne sans que l'empilement ne soit traversé par un courant perpendiculairement au plan des couches.

L'invention concerne ainsi un élément magnétique inscriptible comportant un empilement de couches présentant une couche magnétique d'écriture, caractérisé en ce que l'empilement comporte une dite couche magnétique d'écriture, à savoir une couche centrale en au moins un matériau magnétique présentant une direction d'aimantation parallèle ou perpendiculaire au plan de la couche centrale, qui est prise en sandwich entre une première et une deuxième couches externes en matériaux non magnétiques, la première couche externe comportant un premier matériau non magnétique et la deuxième couche externe comportant un deuxième matériau non magnétique différent du premier matériau non magnétique, au moins le deuxième matériau non magnétique étant électriquement conducteur, en ce qu'il comporte un dispositif pour faire passer un courant d'écriture seulement à travers la deuxième couche externe et la couche centrale et éventuellement à travers la première couche externe seulement dans le cas où celle-ci est électriquement conductrice, ce courant d'écriture circulant dans au moins une direction de courant parallèle au plan de la couche centrale, et un dispositif pour appliquer un champ magnétique ayant une composante selon une direction de champ magnétique soit parallèle, soit perpendiculaire au plan de la couche centrale et à la direction de courant, et en ce que la direction d'aimantation et la direction de champ magnétique sont perpendiculaires entre elles.

L'invention met ainsi en oeuvre un dispositif pour faire passer le courant d'écriture et un dispositif distinct du précédent pour appliquer un champ magnétique. Si la première couche externe n'est pas conductrice, elle n'est traversée par aucun courant lors d'une phase d'écriture. Si elle est conductrice et dans ce cas seulement, elle est traversée par le courant d'écriture.

Avantageusement, le champ magnétique est soit parallèle, soit perpendiculaire au plan de la couche centrale et à la direction du courant.

Deux configurations sont possibles :
Selon une première configuration, la direction de champ magnétique est parallèle à la direction du courant et la direction de l'aimantation est perpendiculaire au plan de la couche centrale magnétique.
Selon une deuxième configuration, la direction de l'aimantation est parallèle à la direction du courant et la direction de champ magnétique est perpendiculaire au plan de la couche centrale magnétique.

Dans ces deux configurations, le courant électrique circule parallèlement à la couche magnétique et ne traverse pas l'empilement dans une direction perpendiculaire au plan des couches, il passe à travers la couche centrale magnétique et au moins la deuxième couche externe dans au moins une direction de courant parallèle au plan des couches, et la mémoire peut être écrite en agissant soit sur le sens du courant, soit sur le sens du champ magnétique.

La couche centrale a avantageusement une épaisseur comprise entre 0,1 nm et 5 nm. Dans la première configuration, cette valeur est de préférence inférieure ou égale à 2 nm. Dans deuxième configuration, cette valeur est de préférence inférieure ou égale à 3 nm.

Dans le cas où la direction de l'aimantation est perpendiculaire au plan de la couche, la couche centrale peut comporter un alliage présentant une anisotropie magnétique perpendiculaire propre, à savoir notamment FePt, FePd, CoPt ou bien encore en un alliage de terre rare / métal de transition qui présente également une anisotropie magnétique perpendiculaire propre, tel que GdCo, ou TbFeCo. La couche centrale magnétique peut aussi comporter un métal ou un alliage présentant dans l'empilement une anisotropie magnétique perpendiculaire induite par les interfaces, notamment Co, Fe, CoFe, Ni, CoNi.

Dans le cas ou la direction de l'aimantation est contenue dans le plan des couches, la couche centrale peut comporter un métal ou un alliage présentant dans l'empilement une anisotropie magnétique planaire notamment Co, Fe, CoFe, Ni, NiFe, CoNi.

Au moins une couche externe conductrice est en un métal non magnétique de préférence Pt, W, Ir, Ru, Pd, Cu, Au, Bi ou en un alliage non magnétique de ces métaux. L'épaisseur d'une telle couche conductrice peut être comprise entre 1nm et 10 nm et est de préférence inférieure ou égale à 5 nm. La valeur de cette épaisseur n'a pas de lien avec la valeur choisie pour l'épaisseur de la couche centrale.

Une couche externe non conductrice est en un matériau isolant électrique, préférentiellement un oxyde diélectrique tel que SiOx, AlOx, MgOx, TiOx, TaOx, HfOx ou bien en un nitrure diélectrique tel que SiNx, BNx. L'épaisseur de cette couche externe est par exemple comprise entre 0,5nm et 200 nm, plus particulièrement entre 0.5 nm et 100 nm et de préférence inférieure à 3nm en particulier si la lecture de l'élément mémoire se fait au moyen du signal de magnétorésistance tunnel.

Les deux couches externes peuvent être conductrices, mais elles sont alors choisies en deux dits métaux ou alliages de métaux non magnétiques différents.

La densité du courant est comprise par exemple entre 10⁴ A/cm² et 10⁹ A/cm², et avantageusement entre 10⁵ A/cm² et 10⁸ A/cm².

Le champ magnétique appliqué peut présenter une valeur comprise entre 0,002 T et 1 T, et avantageusement entre 0,005 T et 0,8 T.

La première couche externe (qui est celle qui n'est pas traversée par le dit courant) peut être recouverte d'une couche de lecture en matériau magnétique et d'une électrode de lecture. Dans le cas où la première couche externe est en métal non magnétique, elle forme avec la couche de lecture, l'électrode de lecture et la couche centrale une vanne de spin. Dans le cas où la première couche externe est diélectrique, elle forme avec la couche de lecture, l'électrode de lecture et la couche centrale une jonction tunnel magnétique. L'épaisseur de la première couche externe est alors de préférence inférieure à 3 nm.

L'élément magnétique peut être structuré de sorte que la première couche externe et la couche centrale forment un plot, alors que la deuxième couche externe forme une piste. La deuxième couche externe peut comporter une région en surépaisseur qui fait partie du plot.

L'invention concerne également un dispositif magnétique inscriptible comportant une pluralité de dits plots dont la deuxième couche externe est constituée par une dite piste qui leur est commune.

Alternativement, la première couche externe, la couche centrale et la deuxième couche externe forment un plot, et le dispositif magnétique inscriptible comporte une pluralité de dits plots, ainsi qu'une piste conductrice bordant la deuxième couche externe desdits plots pour injecter ledit courant à travers la deuxième couche externe et la couche centrale de chacun desdits plots, la deuxième couche externe étant en un matériau électriquement conducteur différent de celui de la piste conductrice.

L'invention sera mieux comprise à la lecture de la description ci-après, en liaison avec les dessins dans lesquels :

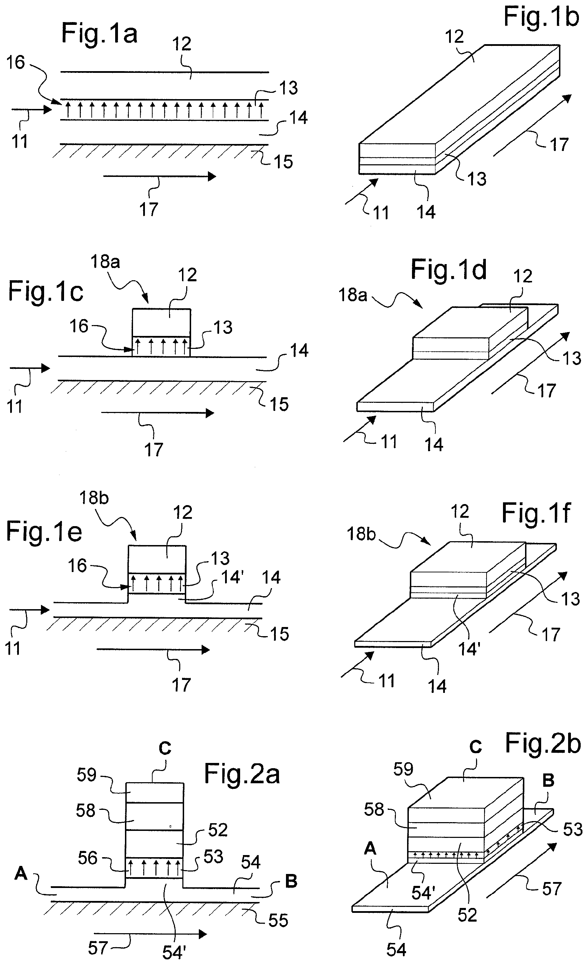

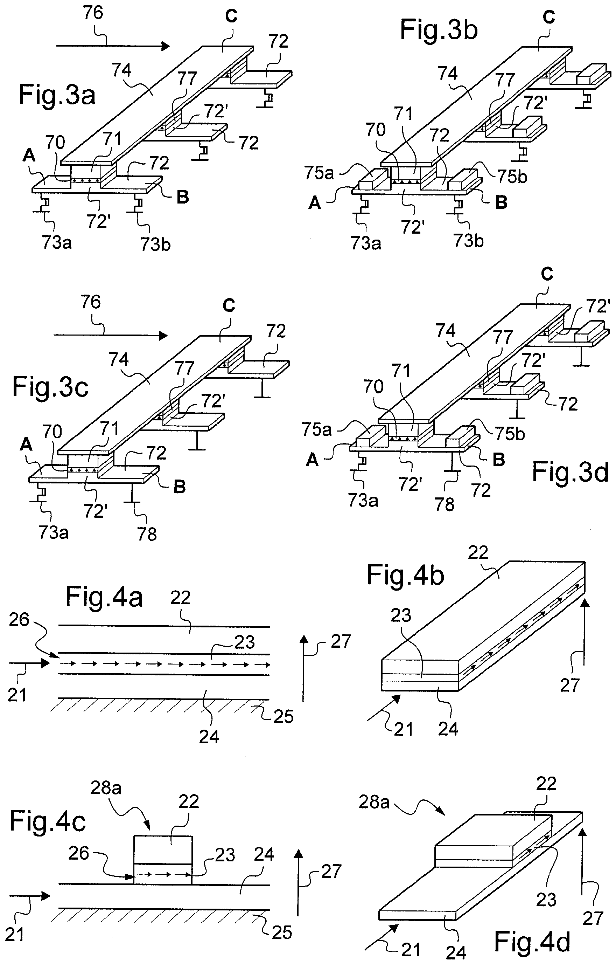

- les figures 1a à 1f illustrent la première configuration de mise en oeuvre de l'invention, dont les figures 2a à 2b représentent un mode de réalisation intégré dans une cellule mémoire magnétique de type "MRAM", et dont les figures 3a à 3d illustrent des modes de réalisation dans lesquels plusieurs éléments de mémoire sont représentés pour illustrer l'architecture de la mémoire.

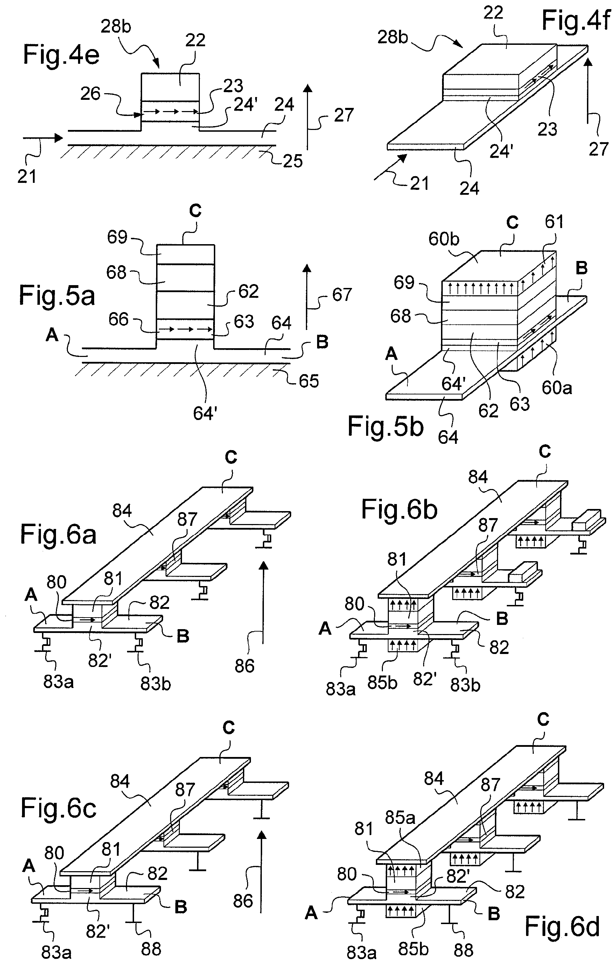

- les figures 4a à 4f illustrent la deuxième configuration de mise en oeuvre de l'invention, dont les figures 5a et 5b représentent un mode de réalisation intégré dans une cellule de mémoire magnétique de type "MRAM" et dont les figures 6a à 6d illustrent des modes de réalisation dans lesquels plusieurs éléments de mémoire sont représentés pour illustrer l'architecture de la mémoire.

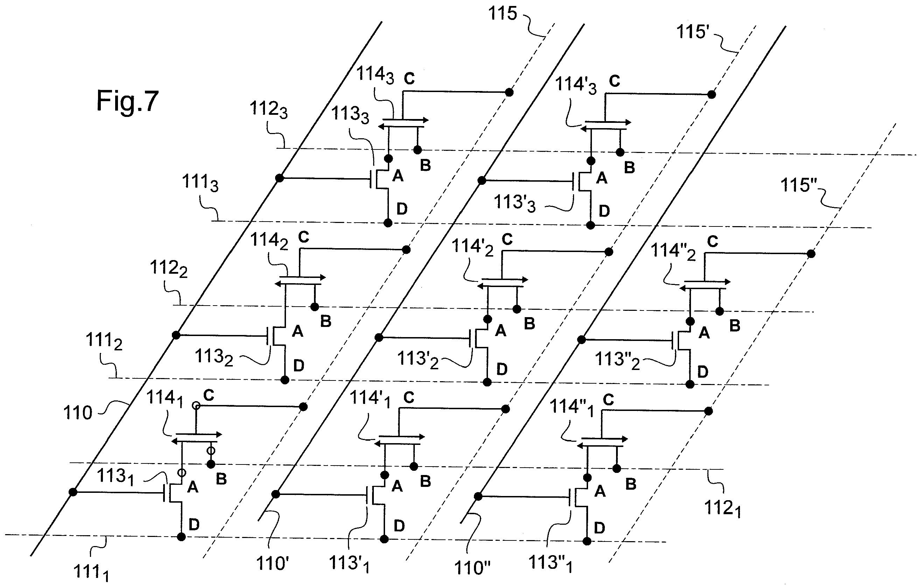

- et la figure 7 est un exemple d'intégration d'un élément magnétique selon l'invention constituant une cellule mémoire, pour former un réseau mono ou bi-dimensionnel.

L'empilement mis en oeuvre dans le cadre de la présente invention, à savoir une couche magnétique centrale, en sandwich entre deux couches externes non magnétiques, dont au moins une est conductrice, les deux couches externes étant en des matériaux différents, a pour effet de créer une asymétrie d'inversion qui génère un champ électrique non compensé dans la couche centrale magnétique. Les électrons se propageant dans ce champ électrique sont soumis dans leur référentiel propre à un champ magnétique appelé champ Rashba *̅H̅_̅{̅R̅}̅*̅ dont la direction est perpendiculaire à la fois au courant et au champ électrique. Ce champ magnétique s'applique donc sur les électrons de conduction.

Les inventeurs ont monté qu'un champ magnétique effectif résultant de ce champ Rashba et de l'interaction d'échange couplant le spin des électrons itinérants et localisés s'applique sur l'aimantation locale. Ainsi, l'article de Ioan MIRON et Collaborateurs, intitulé « Current-driven spin torque induced by the Rashba effect in a ferromagnetic métal layer », publié dans Nature Materials, vol. 9, p. 230-234 (2010) montre un empilement comportant une couche de Pt (3 nm) une couche de Co (0,6 nm) ayant une aimantation perpendiculaire à son plan et donc parallèle à l'axe z, et une couche de AlOx (2 nm) parcourue par un courant circulant parallèlement à l'axe x. Cette situation présente un champ magnétique effectif H_{eff} selon le troisième axe de trièdre, l'axe y. Cette configuration est de ce fait inappropriée à la réalisation d'une mémoire, car ce champ magnétique n'est pas colinéaire à l'aimantation de la couche.

De manière surprenante, les inventeurs ont montré que cet obstacle théorique pouvait être franchi en utilisant ce qui, selon leur interprétation, résulte d'une dynamique de l'aimantation due à l'interaction du champ H_{eff} et d'un champ magnétique externe ayant une composante perpendiculaire à H_{eff}, lorsqu'un courant est injecté dans une structure présentant une asymétrie d'inversion, la direction de la composante perpendiculaire à H_{eff} du champ magnétique étant, soit colinéaire à la direction d'injection du courant (première configuration), soit perpendiculaire à la dite direction (deuxième configuration).

Les figures la à 1f illustrent la première configuration de mise en oeuvre de l'invention selon laquelle la direction du champ magnétique appliqué est parallèle à la direction du courant et la direction de l'aimantation est perpendiculaire au plan de la couche centrale magnétique. Le champ magnétique appliqué est ainsi perpendiculaire à la fois à l'aimantation et à la direction du champ magnétique effectif H_{eff}.

La référence 15 désigne un substrat qui est un isolant électrique, afin de ne pas court-circuiter la structure. Il peut être notamment constitué par un oxyde diélectrique (par exemple SiOx, AlOx, MgOx), ou par un nitrure par exemple SiNx. Il peut être seul ou déposé sur un autre substrat par exemple en silicium.

La référence 13 désigne la couche magnétique plane dont l'aimantation est perpendiculaire à son plan. La référence 16 désigne l'orientation de l'aimantation, qui peut être présente dans un sens ou dans le sens opposé.

Les références 12 et 14 désignent respectivement les première et deuxième couches externes non magnétiques. La deuxième couche externe 14 est celle qui est traversée par un courant lors de l'écriture.

La référence 11 désigne la direction du courant d'écriture qui peut être orienté dans ce sens ou dans le sens opposé, et la référence 17 désigne l'orientation du champ magnétique appliqué, qui est colinéaire à la direction du courant et qui peut être orienté dans ce sens ou dans le sens opposé.

Les figures 1a et 1b montrent un empilement non structuré dans lequel les couches 12, 13 et 14 de l'empilement forment une piste.

Les figures 1c à 1f montrent un empilement structuré dans lequel la couche 14 (dénommée deuxième couche externe) est conductrice et les couches magnétique 13 et non magnétique 12 (dénommée première couche externe) sont seules structurées pour former des plots (Figures 1c et 1d) et dans lequel les trois couches 12, 13, 14 sont structurées pour constituer un plot en intégrant dans le plot une surépaisseur 14' de la couche conductrice 14, de sorte que le plot contienne une partie de l'épaisseur du matériau non magnétique de la couche 14 (Figures 1e et 1f). L'épaisseur à prendre en compte pour la deuxième couche externe est celle de la couche 14 proprement dite et de la surépaisseur 14'.

On notera que la région en surépaisseur 14' n'est pas nécessairement dans le même matériau électriquement conducteur que la couche 14 auquel cas c'est cette surépaisseur seule 14' qui fait fonction de deuxième couche externe non magnétique et c'est son matériau qui est fonctionnel dans l'empilement pour obtenir une asymétrie d'inversion. Le matériau métallique de la couche 14 peut alors être quelconque.

La formation de plots permet de ne retourner l'aimantation que dans les plots, sinon l'aimantation est retournée sur toute la longueur de la piste.

La couche magnétique 13 présente une aimantation perpendiculaire et a une épaisseur assez fine pour que le champ électrique dû aux interfaces ne soit pas négligeable. Son épaisseur ne dépasse typiquement pas 2nm et elle est au maximum de 5nm. Tous les matériaux magnétiques présentant une aimantation perpendiculaire, due par exemple à leur anisotropie magnétique perpendiculaire propre (alliages FePt, FePd, CoPt.... ; alliages terre rare/métaux de transition GdCo, TbFeCo...) ou à l'effet d'une anisotropie magnétique perpendiculaire induite par les interfaces (Co, Fe, CoFe, Ni, CoNi, .... peuvent être utilisés. On peut aussi prendre des matériaux magnétiques non métalliques comme par exemple des semi-conducteurs magnétiques, tels que GaMnAs (GaAs dopé au Mn), On notera que les matériaux semi-conducteurs magnétiques connus ne sont magnétiques qu'à une température inférieure à l'ambiante.

Dans le cas où l'anisotropie perpendiculaire du matériau magnétique est induite par les interfaces, on peut obtenir une aimantation perpendiculaire au plan en agissant sur l'épaisseur de la couche centrale et/ou sur l'état d'oxydation d'une couche externe en oxyde par exemple en modifiant les paramètres du dépôt de cette couche externe en oxyde ou en effectuant un recuit après la réalisation de l'empilement.

Exemple : Un empilement comportant une couche 14 conductrice en Pt (d'épaisseur 3nm), une couche centrale 13 en Co (d'épaisseur 1nm) et une couche 12 en AlOx présente pour un état d'oxydation donné de cette couche d'AlOx, une aimantation perpendiculaire, alors que si l'épaisseur de la couche en Co est égale à 1,5 nm, l'aimantation est dans le plan. Si l'empilement subit un recuit à 300°C pendant 60 minutes sous vide, alors l'aimantation de la couche centrale 13 en Co est perpendiculaire au plan.

Au-delà d'une épaisseur de 3nm pour la couche en Co, on ne pourra pas obtenir d'aimantation hors du plan quel que soit le recuit ou les paramètres d'oxydation si la couche 12 est en AlOx. Si par contre le diélectrique utilisé pour la couche 12 est MgOx, on pourra obtenir une aimantation perpendiculaire pour une épaisseur de la couche centrale supérieure ou égale à 3nm.

L'influence de l'épaisseur d'une couche de cobalt sur les propriétés magnétiques pour différents oxydes (AlOx, MgOx, SiOx) est décrite dans l'article "Domain Patterns and Magnetization reversal Behaviours in Oxide/Co/Pt Films" de Jae Chul LEE et Collaborateurs, paru dans IEEE Transactions on Magnetics, vol. 46 n° 6 June 2010.

L'effet de l'oxydation et du recuit sur les propriétés magnétiques dans les tri-couches Pt/Co/AlOx a été décrit dans l'article 'Influence of Thermal annealing on the perpendicular magnetic anisotropy of Pt/Co/AlOx trilayers" de B. RODMACQ et collaborateurs, paru dans Physical Review B 79 024423, (2009).

L'influence de l'état d'oxydation d'une couche d'oxyde sur les propriétés magnétiques de la couche de cobalt dans un empilement tri-couche platine/cobalt/métal oxydé, a été décrite dans l'article "Analysis of oxygen induced anisotropy crossover in Pt/Co/MOx trilayers" de A. MANCHON et collaborateurs, paru dans Journal of Appplied Physics 104, 043914 (2008).

Les deux couches non-magnétiques 12 et 14 doivent être différentes afin de créer une asymétrie d'inversion dans la structure globale. On choisit avantageusement deux matériaux différents pour chacune de ces couches, par exemple un diélectrique pour l'une des deux et un métal pour l'autre, mais on peut choisir aussi un métal pour chacune d'entre elles. Le cas où les deux couches 12 et 14 sont diélectriques n'est possible que si on ne structure pas un plot mais une piste. On peut alors faire circuler le courant directement dans la couche centrale 13.

Ainsi, chacune des deux couches 12 et 14 peut être constituée par les matériaux suivants, avec la condition que ces couches soient différentes pour que l'empilement global (couches 12, 13, et 14) soit à aimantation perpendiculaire : un oxyde diélectrique (SiOₓ, AlOₓ, MgOₓ, TiOₓ, TaOₓ, HfOₓ,...), un nitrure diélectrique, (SiNₓ, BNₓ,...), un métal non magnétique (Pt, Pd, Cu, Au, Bi,...) un alliage non magnétique de ces métaux, un composé semi-conducteur organique ou non (par exemple GaAs, Si, Ge ou Graphène lié si besoin à un buffer de croissance par exemple un métal tel que l'iridium.

Dans le cas où les couches non magnétiques sont l'une ou l'autre conductrices, c'est-à-dire le cas d'un métal ou d'un alliage, les deux couches externes ne doivent pas avoir la même composition.

L'épaisseur des couches 12 et 14 peut être choisie dans une large gamme de valeurs, typiquement de 0,5 à 200 nm d'épaisseur et plus particulièrement entre 0.5 nm et 100 nm. Dans le cas où la couche 12 est isolante, il n'y a pas d'inconvénient à ce que sa valeur atteigne la limite supérieure indiquée, à savoir 200 nm sauf dans le cas où la lecture du point mémoire se fait au moyen du signal de magnétorésistance tunnel en rajoutant par exemple une couche magnétique et une électrode au dessus de cette couche isolante comme représenté sur les figures 2a et 2b. Dans ce cas l'épaisseur de cette couche isolante sera choisie préférentiellement inférieure à 3nm. Par contre, dans le cas de couches 12 et/ou 14 métalliques, on privilégie des couches fines, typiquement inférieures à 5 nm et généralement inférieures à 10 nm, de façon à ne pas trop diminuer le courant efficace passant dans la couche magnétique à cause de ces canaux conducteurs en parallèle. Dans le cas où la couche 12 est métallique et que la lecture du point mémoire se fait au moyen du signal de magnétorésistance géante en rajoutant par exemple une couche magnétique et une électrode au dessus de cette couche métallique comme représenté sur les figures 2a et 2b, l'épaisseur de cette couche 12 conductrice sera choisie typiquement inférieure à 10 nm et préférentiellement inférieure à 5nm.

Ces différentes couches peuvent être déposées par toute technique connue telle que : évaporation, pulvérisation, dépôt par voie électrochimique, croissance chimique,....

La couche 14 peut être omise dans certaines géométries. La couche magnétique 13 est alors déposée directement sur le substrat isolant 15 et la couche non magnétique 12 est choisie de façon à avoir l'asymétrie d'inversion, en un matériau différent de celui constituant le substrat 15. Il faut néanmoins remarquer que dans le cas où des plots sont structurés, la couche 14 doit être présente et constituée d'un matériau conducteur électrique de façon à pouvoir injecter du courant dans la couche centrale 13 des plots structurés (ici 18a et 18b). Dans ce cas, la portion 14' en surplomb doit être également conductrice pour générer, en combinaison avec la couche 12, l'asymétrie d'inversion qui est recherchée pour générer un champ Rashba et pour permettre d'injecter du courant dans la couche centrale magnétique 13.

L'élément à retourner, que ce soit la piste représentée aux figures 1a et 1b ou un plot reporté ou structuré sur la piste (figures 1c à 1f), est connecté de manière connue en soi avec des électrodes conductrices de façon à injecter dans la couche conductrice 14 un courant suivant la direction 11 représentée figure 1, ce qui permet une injection de courant dans la couche centrale magnétique 13. Un champ magnétique est appliqué sur la structure colinérairement 17 à la direction d'injection du courant 11. Le courant peut être appliqué dans la direction 11 suivant le sens de la flèche *I*₊ ou suivant le sens contraire à celui de la flèche *I*₋. De même, le champ magnétique peut être appliqué dans la direction 17 suivant le sens de la flèche *H*₊ ou suivant le sens contraire à celui de la flèche *H₋*.

Un couple de sens du courant et du champ stabilise une direction d'aimantation.

Par exemple, le couple *I*₊, *H*₊ stabilise la configuration d'aimantation vers le haut comme représenté dans les figures 1a à 1f.

Partant de la configuration où l'aimantation de l'élément est uniformément aimantée vers le haut, on peut la retourner en gardant le sens du courant électrique *I*₊ en changeant le sens du champ magnétique appliqué *H₋.*

Une autre solution est de garder le sens du champ magnétique *H*₊, et de changer le sens du courant électrique *I*₋. Cette solution est préférée, car elle permet d'utiliser un champ magnétique statique par exemple généré par des aimants permanents de façon à ne consommer aucune énergie.

On peut retourner l'aimantation vers le bas en agissant sur le sens du champ appliqué, ce qui conduit au couple (*I*₊, *H₋),* soit en agissant sur le sens du courant appliqué, ce qui conduit au couple (*I₋, H*₊), le couple (*I₋*, *H₊)* étant préféré comme indiqué ci-dessus. Une fois l'aimantation retournée, celle-ci est stable même en l'absence de courant injecté et en présence ou non du champ magnétique statique.

Un changement à la fois du sens du courant et du sens de l'aimantation conduit au couple (I₋, H₋) qui stabilise également une aimantation vers le haut.

De manière générale il faut remarquer qu'il n'est pas nécessaire que le champ externe soit exactement parallèle à la direction du courant. Il suffit d'avoir un champ magnétique externe dans un plan perpendiculaire à l'aimantation, ce champ magnétique externe ayant une composante non nulle parallèle au courant. On observe un retournement jusqu'à un angle de 60° entre le champ appliqué et le courant.

Les valeurs typiques des densités de courant injectées dans la couche 14 sont comprises entre 10⁴ A/cm² et 10⁹ A/cm², et elles sont avantageusement comprises entre 10⁵ A/cm² et 10⁸ A/cm².

Les valeurs typiques de la composante du champ magnétique appliqué le long de la direction du courant sont comprises entre 20 Oe-10 kOe, c'est-à-dire entre 0,002T et 1T. Avantageusement, on choisira une valeur comprise entre 50 Oe (0,005T) et 8000 Oe (0,8T). Celui-ci doit être maintenu à une valeur assez faible pour de ne pas induire une diminution trop grande de la barrière d'énergie séparant les deux orientations d'aimantation, ce qui provoquerait des retournements non désirés.

A cet effet, la valeur du champ magnétique appliqué est choisie très inférieure au champ effectif d'anisotropie de la couche magnétique.

Par exemple, une couche centrale en Co entre une couche 14 en Pt et une couche 12 de MgO a un champ effectif d'anisotropie de 0,8T (8000 Oe) et on peut appliquer sans problème un champ magnétique de 0,008 T (800 Oe).

La valeur du champ magnétique appliqué peut être en pratique choisie comme étant entre 3 et 10 fois inférieure à la valeur du champ effectif d'anisotropie, et plus particulièrement entre 4 et 10 fois inférieure à cette valeur.

Le champ magnétique peut être appliqué de différentes façons, par exemple de façon simple à l'aide d'un courant parcourant une ou plusieurs bobines de façon à générer un champ global sur l'ensemble du dispositif ; soit au moyen de pistes parcourues par un courant comme utilisées dans les mémoires MRAM à retournement induit par un champ magnétique ; soit, de façon préférentielle par des aimants permanents placés au voisinage d'au moins un plot à retourner. Cette solution a l'avantage important de ne pas induire de consommation énergétique pour la génération du champ magnétique. Ces aimants permanents peuvent être obtenus par la structuration d'un dépôt magnétique, ce qui facilite l'intégration de cette technique de retournement dans des dispositifs fonctionnels par exemple de type mémoire ou logique.

On peut également mettre en oeuvre un ou plusieurs aimants permanents placés à l'extérieur de l'ensemble des plots afin de générer un champ sur l'ensemble de la structure.

Les figures 2a et 2b sont un exemple d'empilement utilisable dans une cellule de mémoire inscriptible MRAM.

La référence 53 représente la couche centrale magnétique prise en sandwich entre deux matériaux non magnétiques différents 52 et 54, pour réaliser l'empilement tel que décrit ci-dessus, sur un substrat 55 électriquement isolant.

La référence 57 désigne la direction du champ magnétique extérieur appliqué.

Au-dessus de l'empilement sont disposées pour la lecture une couche 58 d'un matériau magnétique et une électrode supérieure 59 pouvant contenir une ou plusieurs couches conductrices (magnétiques ou non magnétiques).

La fonction de la couche 58 est de permettre que la structure 53, 52, 58 présente des valeurs de résistance électrique différentes suivant le sens de l'aimantation 56 de la couche 53 (signal de magnétorésistance). Elle n'intervient que pour la lecture et n'a aucun effet sur la manipulation de l'aimantation de la couche 53.

En d'autres termes, l'écriture et la lecture sont définies de manière indépendante et peuvent être optimisées séparément.

L'électrode 59 peut comporter une couche ou bien de manière connue en soi un empilement de différentes couches fonctionnelles. Il peut contenir par exemple :
- un empilement définissant un antiferromagnétique synthétique de façon à limiter les champs rayonnés sur la couche que l'on cherche à manipuler 53, par exemple un empilement comprenant une couche ferromagnétique séparée de la couche ferromagnétique 58 par une très fine couche d'un matériau métallique non magnétique, typiquement 0,3 nm de ruthénium (Ru), les valeurs des aimantations des deux couches ferromagnétiques étant le plus proche possible de telle sorte que le couplage antiferromagnétique entre elles qui est dû à la présence de la couche de ruthénium résulte en un champ total rayonné par ces trois couches sur la couche 53 qui soit nul ou quasi nul ;
- ou bien un matériau magnétique antiferromagnétique couplé par échange à la couche 58 de façon à stabiliser cette couche 58 dite de référence ;
- ou bien des matériaux conducteurs non magnétiques pour réaliser des contacts électriques ;
ou encore une combinaison de ces différentes possibilités par exemple un matériau antiferromagnétique adjacent à un matériau ferromagnétique de manière à stabiliser l'aimantation de celui-ci par le couplage entre ces deux matériaux, ce matériau ferromagnétique étant séparé de la couche 58 par une fine couche métallique, typiquement 0,3nm de Ru de façon que le couplage magnétique entre ces deux couches ferromagnétiques soit antiferromagnétique. Enfin, le première matériau magnétique est recouvert d'une ou plusieurs couches conductrices non magnétiques, par exemple 5nm de Ta recouvert de 7nm de Ru. On trouvera des exemples de telles combinaisons par exemple dans des empilements magnétiques utilisés pour le retournement par STT décrit dans B. DIENY et al., Int. J. Nanotechnology, vol. 7, 591 (2010).

Deux configurations principales peuvent être distinguées suivant la nature de la couche 52 : si elle est en métal non magnétique, la structure 53, 52, 58 est de type vanne de spin, tandis que si la couche 52 est diélectrique, la structure 53, 52, 58 est du type jonction tunnel magnétique. Le signal de magnétorésistance étant beaucoup plus important pour ces structures, ce seront celles-ci qui seront privilégiées. De même, pour optimiser encore le signal de magnétorésistance, on privilégie dans l'un et l'autre cas, la configuration dans laquelle l'aimantation de la couche 58 est colinéaire, soit parallèle, soit antiparallèle, à celle de la couche 53.

A, B et C (Figure 2a et 2b) désignent trois bornes de connexion électrique. Dans la phase d'écriture, un courant d'écriture est injecté entre les bornes A et B (de façon équivalente, une tension est appliquée entre ces bornes de façon à faire circuler un courant). Le courant d'écriture passe dans la couche magnétique 53 et produit dans cette couche un champ magnétique efficace dû au champ Rashba et à l'interaction d'échange s-d, agissant sur l'aimantation locale (voir l'article précité de MIRON et collaborateurs). Ce champ efficace H_{eff} sera dénommé par la suite de façon équivalente par champ de spin-orbite ou champ efficace H_{eff}. Ce champ de spin-orbite, en combinaison avec le champ extérieur appliqué permet selon l'invention, la manipulation de l'aimantation. Dans le cas où la couche 52 est constituée par un matériau diélectrique, le courant injecté latéralement ne passe pas à travers cette couche et ne l'endommage pas. La lecture de l'information stockée, typiquement l'orientation de l'aimantation dans la couche 53, se fait aussi bien pour une structure de type jonction tunnel que de type vanne de spin, en injectant un courant de faible intensité (par exemple de l'ordre de quelques µA ou de quelques dizaines de µA pour le cas de jonction tunnel) entre les bornes C et B (ou de façon équivalente entre les bornes C et A), et en mesurant la tension entre ces bornes ; ou bien en appliquant une tension constante entre les bornes B et C, (ou de façon équivalente entre les bornes C et A), et en mesurant le courant qui circule entre ces bornes de façon à mesurer dans les deux cas la résistance entre les bornes considérées. Celle-ci aura deux valeurs différentes selon que la direction d'aimantation 56 est parallèle ou anti-parallèle à celle de la couche de référence 58. Le courant de lecture a une faible valeur de sorte que la barrière tunnel (dans le cas où la couche 52 est diélectrique) ne saurait être endommagée.

Comme indiqué plus haut dans la description, le champ magnétique appliqué peut conserver un sens constant, le retournement de l'aimantation étant obtenu par le sens du courant à travers les couches 54 et 53. Cette solution est préférée, car elle est facilement intégrable et n'implique aucune consommation électrique supplémentaire (dans le cas où on utilise des aimants permanents).

Sinon, l'aimantation peut être bien entendu retournée simplement en inversant le sens du champ magnétique appliqué, en conservant le sens du courant injecté.

Des exemples d'architecture de mémoire sont maintenant présentés en relation avec les figures 3a à 3d, dans lesquels les figures 3b et 3d mettent en oeuvre l'intégration d'aimants permanents.

Les figures 3a à 3d représentent quatre exemples de mise en oeuvre d'une architecture de mémoire, selon la première configuration, avec mise en oeuvre de la structure selon les figures 2a et 2b.

La couche 70 de matériau magnétique est prise en sandwich entre une couche conductrice 72 et un empilement 71 comportant les couches 52, 58 et 59 des figures 2a et 2b pour lire l'aimantation de la couche 70 par une jonction tunnel (ou une vanne de spin).

La ligne de lecture 74 permet d'alimenter le point C des points mémoire d'une même ligne. Une région en surépaisseur 72' équivalente à la région 54' est éventuellement présente.

Un champ magnétique statique de direction 76 est appliqué parallèlement à la direction du courant qui traverse la couche conductrice 72.

Le champ statique peut être appliqué à l'ensemble de la mémoire par un ou plusieurs aimants permanents, ou bien à chacun des plots formés par les empilements élémentaires (3 sont représentés) par exemple au moyen d'aimants permanents 75a et 75b disposés en vis-à-vis de chaque plot.

Deux transistors par exemple de type métal-oxyde-semiconducteur ou MOS 73a et 73b peuvent être mis en oeuvre pour l'application du courant dans un sens et en sens inverse à travers la couche conductrice 72 (figures 3a et 3b), ou bien un seul transistor 73a est utilisé, l'autre extrémité 78 étant portée à un potentiel constant (figures 3c et 3d).

La couche 72 est structurée sous la forme d'une piste d'amenée de courant. Elle peut comporter une couche d'un autre matériau conducteur située sur la couche 72.

Pour un point mémoire donné, l'injection de courant pour l'écriture peut se faire selon deux modes.

On utilise dans un premier mode deux transistors 73a et 73b fonctionnant en commutation, dont la borne libre est portée alternativement à la masse pour l'un et à une tension V_{dd} pour l'autre, la tension V_{dd} étant choisie pour faire circuler un courant de valeur choisie, dans un sens ou dans l'autre suivant que le transistor 73a ou le transistor 73b est porté à la tension V_{dd}.

On utilise dans un deuxième cas un seul transistor 73a, l'autre extrémité de la piste 72 étant portée en 78 à une tension fixe.

### Fonctionnement symétrique :

La piste connectée au transistor est portée au potentiel V_{dd} (ou à la masse) tandis que l'autre piste connectée en bout de la piste 72 en 78 est connectée à la masse (ou à V_{dd}). Cette configuration permet de générer plus de courant que celle qui suit.

### Fonctionnement asymétrique :

La piste connectée à l'extrémité de la piste 72 en 78 est portée à un potentiel intermédiaire, par exemple V_{dd} /2, tandis que celle reliée au transistor 73a est portée respectivement au potentiel V_{dd} ou à la masse suivant le sens souhaité pour le courant. Cette configuration permet de générer moins de courant. Dans la configuration de l'invention, le courant peut être envoyé sur une surface bien plus petite que celles utilisées dans les techniques conventionnelles, et ce courant est suffisant pour faire fonctionner le dispositif. Dans cet exemple de réalisation, on fait une économie de consommation sur le fonctionnement.

Dans la deuxième configuration (Figures 4a à 4f), la direction 26 de l'aimantation de la couche magnétique est située dans le plan de celui-ci et est parallèle à la direction du courant injecté, et le champ magnétique par exemple constant qui est appliqué est perpendiculaire à la direction d'aimantation 26, ainsi qu'à la direction du champ magnétique de spin-orbite (champ magnétique efficace).

Le champ magnétique appliqué n'a pas besoin d'être parfaitement perpendiculaire à la direction du champ magnétique H_{eff} mais doit avoir une composante non nulle, que l'on appellera dans la suite composante utile du champ magnétique appliquée, suivant la direction perpendiculaire à H_{eff} (ou au champ de spin-orbite) et à la direction d'aimantation 26. L'angle entre le champ magnétique appliqué et la composante utile de ce champ peut atteindre 60°.

Comme pour les figures 1a à 1f, trois géométries sont représentées, à savoir sous forme de piste (Figures 4a et 4b) et de plots, la piste conductrice 24 longeant le plot (Figures 4c et 4d) ou bien présentant une région surélevée 24' (Figures 4e et 4f) qui est électriquement conductrice (en général métallique) et qui n'est pas nécessairement dans le même matériau que la piste 24, auquel cas c'est cette surépaisseur 24' qui fait fonction de couche externe non magnétique et c'est son matériau qui est fonctionnel dans l'empilement pour obtenir une asymétrie d'inversion. Le matériau métallique de la couche 24 peut être alors quelconque.

Pour chacune des géométries, 21 représente la direction du courant injecté et 27 la direction de la composante utile du champ magnétique extérieur qui est appliqué (d'après les remarques faites ci-dessus pour la direction). Cette direction est perpendiculaire au plan des couches 23 et 24 et donc à la direction d'aimantation 26 de la couche 23 et à la direction 21 du courant injecté.

Une couche 23 d'un matériau magnétique de faible épaisseur est prise en sandwich entre deux couches de matériaux non magnétiques différents, à savoir la couche 22 située au dessus et la couche 24 située en dessous, par laquelle le courant est injecté.

L'empilement typique comprend un substrat isolant électrique 25, par exemple un oxyde diélectrique (par exemple SiOx, AlOₓ, MgOx) ou par exemple un nitrure de silicium par exemple SiNₓ, sur lequel est déposée la structure formant l'empilement. Une couche fine d'un matériau magnétique (ou d'une combinaison de matériaux magnétiques ou de couches magnétiques 23), par exemple une couche de 3 nm de cobalt, prise en sandwich entre deux couches 22 et 24 en matériaux non magnétiques différents, par exemple une couche diélectrique 22 et une couche 24 en un matériau électriquement conducteur, en général en métal, par exemple du platine. Les couches 22 et 24 peuvent aussi être en deux métaux différents. L'aimantation de la couche magnétique 23 est contenue dans le plan, orientée suivant l'axe de la piste 26. Le courant est injecté suivant la direction 21 qui est parallèle à la direction de l'aimantation et un champ magnétique extérieur est appliqué dans un plan perpendiculaire à l'aimantation avec une composante utile suivant la direction 27 perpendiculaire au plan des interfaces (ou au champ de spin orbite).

Un plot 28a ou 28b (figures 4c à 4f) contenant le matériau non magnétique 22 et le matériau magnétique 23 peut être formé sur la piste conductrice 24 dans le but de ne retourner que l'aimantation contenue dans ce plot. Le plot 28b (figures 4e et 4f) peut contenir une partie 24' de l'épaisseur du matériau non magnétique 24. Le plot 28a ou 28b peut avoir toutes les géométries : carré, rectangle, disque, ellipse, ou encore chacune de ces géométries déformées, le principe étant que l'aimantation soit dirigée le long de la piste. Pour cela, on privilégie une forme elliptique de grand axe parallèle à l'axe de la piste.

Comme dans les cas décrits ci-dessus, la portion surélevée 24' peut être également en un matériau conducteur différent du matériau de la couche 22 et de la piste conductrice 24.

Le matériau du substrat 25 peut être choisi parmi les mêmes matériaux que pour la première configuration.

La couche magnétique 23 doit présenter à la différence de la couche 13, une aimantation planaire et avoir une épaisseur assez fine pour que le champ magnétique efficace H_{eff} dû au courant injecté et agissant sur l'aimantation locale ne soit pas négligeable.

Dans le cas où les couches 22 et 24 sont conductrices non magnétiques, on cherche à avoir une couche 23 ayant une épaisseur telle que l'anisotropie magnétique soit dans le plan. Cette épaisseur est typiquement plus importante que celle de la couche 13 entourée par deux couches 12 et 14 (figures 1a à 1f) identiques à 22 et 24. Dans le cas où une des deux couches typiquement 22, est en un matériau isolant électrique, typiquement un oxyde tel que AlOx, MgOx, TiOx, TaOx, ...., on peut à la fois augmenter l'épaisseur de la couche magnétique ou varier l'état d'oxydation de la couche d'oxyde, soit par exemple au cours du dépôt de cette couche, ou bien après ce dépôt au moyen de recuits sous vide. Des exemples de tels traitements peuvent être trouvés dans les publications déjà cités de B. RODMACQ et collaborateurs et de A. MANCHON et collaborateurs.

Ainsi, l'épaisseur de cette couche magnétique peut dans certains cas, en fonction des paramètres d'oxydation et/ou de recuit, être identique à celle utilisée dans la première configuration décrite précédemment, alors que l'aimantation est perpendiculaire dans cette première configuration et planaire dans celle décrite ici. Cette épaisseur pour la deuxième configuration ne dépasse typiquement pas 5nm, et est de préférence inférieure ou égale à 3 nm. Tous les matériaux magnétiques présentant une aimantation planaires (Co, Fe, CoFe, NiFe, CoNi,...) peuvent être utilisés. On peut aussi utiliser des matériaux magnétiques non métalliques comme par exemple des semi-conducteur magnétiques tels que le (Ga,Mn)As suivant les conditions d'élaboration.

A titre d'exemple illustratif qui concerne le cas (Ga,Mn)As, obtenu par croissance par exemple sur du GaAs (100), on aura après dopage du GaAs avec du Mn une contrainte compressive qui conduira à une anisotropie planaire tandis que quand on le fera croître sur du GaInAs, on aura une autre contrainte et une anisotropie magnétique résultantes perpendiculaire aux plans. On trouve cela par exemple dans : "Anisotropie magnetization relaxation in ferromagnetic Gal-xMnxAs thin tilms", Kh. KHAZEN, H. J. VON BARDELEBEN, M. CUBUKCU, J. L. CANTIN, V. NOVAK, K. OLEJNIK, M. CUKR, L. THEVENARD, A. LEMAITRE, Phys. Rev. B 78 195210 (2008) ; ou encore dans "Ferromagnetic semiconductors : "moving beyond (Ga, Mn)As", A. H. MACDONALD, P. SCHIFFER, N. SAMARTH, Nature Materials 4, 195 - 202 (2005), doi:10.1038/nmat1325.

Tout ce qui a été écrit pour les couches 12 et 14 selon la première configuration reste valable pour les couches non-magnétiques 22 et 24 à la différence que la restriction imposée qui était que l'empilement global (couches 12, 13 et 14) soit à aimantation perpendiculaire est remplacé maintenant par la restriction que l'empilement, soit à aimantation planaire.

### Omission de la couche 24

Tout ce qui a été écrit pour la couche 14 peut être repris ici.

### Retournement de la couche

De même, tout ce qui été écrit concernant le retournement de l'aimantation dans la première configuration peut être repris à l'identique ici en considérant les directions d'aimantation et de champ extérieur appliquées présentées précédemment. Il en va de même pour les valeurs du champ magnétique, et de la densité de courant, ainsi que pour l'application du champ magnétique.

Dans le cas d'une aimantation planaire, le champ d'anisotropie est de l'ordre de 4πMs, où Ms est l'aimantation à saturation, soit environ 1,5 T pour du Co. La valeur du champ magnétique appliqué peut être en pratique entre 3 et 10 fois inférieure à la valeur du champ effectif d'anisotropie et de préférence entre 4 et 10 fois inférieure à celui-ci. Les valeurs du champ magnétique appliqué peuvent donc être plus importantes que pour la première configuration, puisque le champ d'anisotropie est en général supérieur.

Les figures 5a et 5b représentent un exemple d'empilement utilisable dans une cellule de mémoire magnétique MRAM ou de composant logique, afin de permettre à la fois l'écriture et la lecture.

Un matériau magnétique 63 de faible épaisseur qui présente une aimantation dans la direction 66 parallèle à son plan est pris en sandwich entre deux couches 62 et 64 de matériaux non magnétiques différents, le matériau 64 formant une piste conductrice sur un substrat isolant, pourvue éventuellement d'une région 64' en surépaisseur. Le champ magnétique externe est appliqué selon la direction 67 perpendiculaire au plan des interfaces entre les couches empilées. A cet empilement sont superposées successivement une couche 68 d'un matériau magnétique, et une électrode supérieure 69 présentant une ou plusieurs couches de matériaux conducteurs qui peuvent être ou non magnétiques pour former comme pour la première configuration un empilement tel que décrit en liaison avec les figures 4c à 4f. A, B et C représentent trois points de prise de contact électrique respectivement à des extrémités de la piste 64 (contacts A et B), et sur l'électrode supérieure 69 (contact C).

La figure 5b montre également un exemple d'intégration au plot d'aimants à aimantation permanente 60a et 60b pour générer le champ magnétique dans la direction 67. Pour permettre la prise de contact C, l'aimant permanent 60b est en matériau conducteur.

Les figures 6a à 6d illustrent une architecture de mémoire qui met en oeuvre la structure décrite aux figures 5a et 5b, selon quatre modes de mise en oeuvre.

Dans chacun des cas, la couche magnétique 80 est prise en sandwich entre une couche 82, 82' d'amenée de courant et un empilement 81 qui comporte les couches 62, 68, et 69 des figures 5a et 5b, pour définir comme pour la première configuration un empilement de type jonction tunnel si la couche 62 est diélectrique (ou vanne de spin si la couche 62 est en métal non-magnétique) pour lire l'état d'aimantation de la couche 80.

A la figure 6a, l'injection du courant d'écriture dans la piste 82 est commandée par deux transistors 83a et 83b.

La lecture de l'information stockée, typiquement l'orientation de l'aimantation dans la couche 80, se fait aussi bien pour une structure de type jonction tunnel que de type vanne de spin, en injectant un courant de lecture de faible intensité (par exemple de l'ordre de quelques micro-ampères ou dizaines de micro-ampères pour le cas de jonctions tunnel) entre les bornes C (ligne 84) et B (ou de façon équivalente entre les bornes C et A) et en mesurant la tension entre ces bornes, ou bien en appliquant une tension de lecture constante entre les bornes C et B (ou de façon équivalente entre les bornes C et A) et en mesurant le courant de lecture circulant entre ces bornes, de façon dans tous les cas à mesurer la résistance entre les bornes considérées. Celle-ci aura deux valeurs différentes selon que la direction d'aimantation 66 de la couche 80 est parallèle ou antiparallèle à celle de la couche de référence 68. Le courant de lecture a une faible valeur de sorte que la barrière tunnel (dans le cas où la couche 62 est diélectrique) ne saurait être endommagée.

Des aimants permanents 85a et 85b peuvent être intégrés à la structure, par exemple respectivement en dessous de la piste 82 et au-dessus de l'empilement 81, pour appliquer le champ statique dans la direction 86 perpendiculaire au plan de la couche 80. Le matériau constituant l'aimant permanent 85a doit être conducteur pour ne pas perturber la lecture.

Les figures 6c et 6d diffèrent des figures respectivement 6a et 6b par le fait qu'un seul transistor de lecture est mis en oeuvre, l'autre extrémité 88 (point B) de la ligne 82 d'amenée de courant étant portée à un potentiel constant.

Un circuit de commande peut être mis en oeuvre dans tous les cas pour gérer les opérations d'écriture et/ou de lecture.

Le retournement de l'aimantation de la couche 80 s'effectue ici grâce à un courant parcourant l'électrode inférieure 82 dans un sens ou dans l'autre en présence du champ magnétique statique de direction 86, la couche externe de l'empilement 82, 80, 81 étant structurée sous la forme d'une piste 82 d'amenée de courant, avec éventuellement une région conductrice en surépaisseur 82'. Comme dans les cas précédents, la partie 82' en surépaisseur peut être ou non dans le même matériau conducteur que la piste 82.

Pour un point mémoire donné, l'injection de courant pour l'écriture peut se faire selon deux modes.

On utilise dans un premier mode deux transistors 83a et 83b fonctionnant en commutation, dont la borne libre est portée alternativement à la masse pour l'un et à une tension V_{dd} pour l'autre, la tension V_{dd} étant choisie pour faire circuler un courant de valeur choisie, dans un sens ou dans l'autre suivant que le transistor 83a ou le transistor 83b est porté à la tension V_{dd}.

On utilise dans un deuxième cas un seul transistor 83a, l'autre extrémité de la piste 82 étant portée en 88 à une tension fixe.

### Fonctionnement symétrique

La piste connectée au transistor est portée au potentiel V_{dd} (ou à la masse) tandis que l'autre piste connectée en bout de piste 82 en 88 est connectée à la masse (ou à V_{dd}). Cette configuration permet de générer plus de courant que celle qui suit.

### Fonctionnement asymétrique

La piste connectée à l'extrémité de la piste 82 en 88 est portée à un potentiel intermédiaire, par exemple V_{dd}/2, tandis que celle reliée au transistor 83a est portée respectivement au potentiel V_{dd} ou à la masse suivant le sens souhaité pour le courant. Cette configuration permet de générer moins de courant. Dans la configuration de l'invention, le courant peut être envoyé sur une surface bien plus petite que celles utilisées dans les techniques conventionnelles, et ce courant est suffisant pour faire fonctionner le dispositif. Dans cet exemple de réalisation, on fait une économie de consommation sur le fonctionnement.

La figure 7 est un exemple de schéma électrique d'intégration d'un élément de mémoire pour former un réseau de cellules mémoires à deux dimensions par exemple avec une jonction tunnel. Les dispositifs permettant d'appliquer un champ magnétique ne sont pas représentés dans un but de simplification.

Dans une direction, sont présentes des lignes de bit (bit line) ou lignes de digits 111₁, 111₂, 111₃, etc... connectées au drain des transistors 113₁, 113₂, 113₃, 113'₁, 113'₂, 113'₃, 113"₁, 113"₂, etc... et des lignes de bitconjuguées 112₁, 112₂, 112₃,... qui forment un réseau à deux dimensions.

Dans la direction perpendiculaire, on a des pistes de commande 110, 110', 110", ... des portes des transistors 113₁, 113₂, 113₃, 113'₁, 113'₂, 113'₃, 113"₁, 113"₂, etc... qui forment des lignes de mot (word lines).

Les repères 114₁, 114₂, 114₃, 114'₁, 114'₂, 114'₃, etc... désignent schématiquement un empilement selon l'invention comportant une jonction tunnel (ou une vanne de spin). La jonction tunnel ou la vanne de spin n'est pas traversée par un courant perpendiculairement au plan de ses couches lors d'une phase d'écriture, et elle n'est parcourue par un courant perpendiculairement au plan de ses couches que lors d'une phase de lecture.

Les points caractéristiques A, B et C ont été indiqués. Ils correspondent à ceux qui sont indiqués aux figures 2a, 2b, 3c, 3d, 5a, 5b, 6c et 6d (montage avec un seul transistor).

Les points A sont connectés aux sources des transistors 113₁, 113₂, 113₃, 113'₁, 113'₂, etc....

Les points B sont connectés à une ligne de bit conjuguée 112₁, 112₂, 112₃, etc... et les points C à une ligne de polarisation 115, 115', etc.... Les drains D des transistors 113₁, 113₂, 113₃, 113'₁, 113'₂, etc... sont connectés aux lignes de bit 111₁, 111₂, 111₃, etc...

Le bas des empilements 114₁, 114₂, etc... est donc la couche dont on change l'aimantation au moyen du courant d'écriture.

Dans tous les cas, on peut inverser les sources et les drains des transistors, les sources pouvant alors être connectées aux lignes de bit 111₁, 111₂, etc... et les drains aux points A.

Dans la phase d'écriture, d'un point mémoire, par exemple 114₁, la ligne de bit (ou "bit line") 111₁ et la ligne de bit conjuguée 112₁ qui sont associées à ce point mémoire sont portées selon le sens d'aimantation que l'on désire au potentiel Vdd (ou à la masse) et à la masse (ou au potentiel Vdd) dans le cas du fonctionnement symétrique décrit ci-dessus. Les autres lignes de bit 111₂, etc... et lignes de bit conjuguées 112₂, etc... associées aux autres points mémoire sont inactives. La ligne de mot 110 associée est portée au potentiel de commande nécessaire à la fermeture du transistor 113₁ (équivalent au transistor 73a ou 83a des figures précitées), pour permettre la circulation du courant d'écriture à travers le transistor 113₁.

Le courant d'écriture passe donc entre les points A et B dans un sens ou dans l'autre suivant le sens de l'aimantation que l'on désire. De façon à n'écrire que cette cellule, les autres lignes de mot 110', 110", etc... sont portées au potentiel qui ouvre les transistors. Aucun courant ne traverse perpendiculairement au plan des couches l'empilement de type jonction tunnel ou vanne de spin au risque de l'endommager. A cet effet, les lignes de polarisation 115, 115', etc... connectées aux points C des empilements sont inactives (ou ouvertes) dans cette phase d'écriture.

Dans la phase de lecture, par exemple du point mémoire 114₁, la "ligne de bit conjuguée" 112₁ associée à ce point mémoire est ouverte, ainsi que toutes les autres lignes de bit conjuguée" 112₂, etc... de façon à empêcher tout courant d'y circuler. La ligne de polarisation 115 associée au point mémoire envisagé est portée à un potentiel permettant le passage du courant de lecture (faible) dans la jonction tunnel ou dans la vanne de spin, tandis que toutes les autres lignes de polarisation 115', etc... sont déconnectées. La «ligne de mot» 110 associée est portée au potentiel permettant la fermeture du transistor 113₁ et un courant peut donc passer à travers la jonction tunnel ou la vanne de spin entre les points C et A. Pour ne lire que cette jonction tunnel ou cette vanne de spin, les autres lignes de mot « word line » 110', etc... sont portées au potentiel qui ouvre les transistors. Dans le cas d'une jonction tunnel, la lecture peut alors se faire par exemple suivant l'état de l'art par comparaison au moyen d'un amplificateur du courant passant dans la jonction à un courant de référence. Ce courant de lecture de faible densité de courant, passant perpendiculairement aux plans de l'empilement ne permet pas d'écrire la jonction dans cette phase de lecture. La procédure est la même dans le cas d'une vanne de spin.

## Revendications

1. Elément magnétique inscriptible comportant un empilement de couches dont une couche magnétique d'écriture (13, 53, 70, 23, 63, 80) en au moins un matériau magnétique présentant une direction d'aimantation parallèle ou perpendiculaire à son plan prise en sandwich entre une première (12, 52, 71, 22, 62) et une deuxième (14, 54, 72, 24, 64, 82,) couches externes composées respectivement d'un premier et d'un deuxième matériau non magnétique, où
- le premier et le deuxième matériau non magnétique sont différents
- le deuxième matériau non magnétique est conducteur ;
et
- un dispositif pour appliquer un champ magnétique ayant une composante selon une direction soit parallèle, soit perpendiculaire au plan de la couche magnétique d'écriture (13, 53, 70, 23, 63, 80), tel que la direction d'aimantation et la direction de champ magnétique, sont perpendiculaires entre elles ;
l'élément étant **caractérisé en ce qu'**il comporte :
- un dispositif pour faire passer un courant d'écriture à travers la deuxième couche externe et la couche magnétique d'écriture, ce courant d'écriture circulant dans une direction de courant parallèle au plan de la couche magnétique d'écriture et ne traversant pas l'empilement dans une direction perpendiculaire au plan des couches,
ladite une composante de la direction du champ magnétique appliqué par le dispositif étant soit parallèle soit perpendiculaire à la direction de courant.

2. Elément magnétique selon la revendication 1, caractérisé en ce le champ magnétique est soit parallèle, soit perpendiculaire au plan de la couche magnétique d'écriture et à la direction du courant.

3. Elément magnétique selon une des revendications 1 ou 2, **caractérisé en ce que** la direction de champ magnétique est parallèle à la direction du courant et **en ce que** la direction d'aimantation est perpendiculaire au plan de la couche magnétique d'écriture (13, 53, 70).

4. Elément magnétique selon une des revendications 1 ou 2, **caractérisé en ce que** la direction d'aimantation est parallèle à la direction du courant et **en ce que** la direction de champ magnétique est perpendiculaire au plan de la couche magnétique d'écriture (23, 63, 80).

5. Elément magnétique selon une des revendications 3 ou 4, **caractérisé en ce que** la couche magnétique d'écriture (13, 23, 53, 63, 70, 80) a une épaisseur comprise entre 0,1 nm et 5 nm.

6. Elément magnétique selon la revendication 3, **caractérisé en ce que** la couche magnétique d'écriture (13, 53, 70, 23, 63, 80) comporte un alliage présentant une anisotropie magnétique perpendiculaire propre, à savoir, notamment FePt, FePd, CoPt ou bien encore un alliage de terre rare / métal de transition, notamment GdCo, TbFeCo.

7. Elément magnétique selon la revendication 3, **caractérisé en ce que** la couche magnétique d'écriture comporte un métal ou un alliage présentant dans l'empilement une anisotropie magnétique perpendiculaire induite par les interfaces, notamment Co, Fe, CoFe, Ni, CoNi.

8. Elément magnétique selon la revendication 4 , **caractérisé en ce que** la couche magnétique d'écriture comporte un métal ou un alliage présentant dans l'empilement une anisotropie magnétique planaire, notamment Co, Fe, CoFe, Ni, NiFe, CoNi.

9. Elément magnétique selon une des revendications précédentes, **caractérisé en ce qu'**au moins une couche externe est conductrice, est en un métal non-magnétique tel que Pt, W, Ir, Ru, Pd, Cu, Au, Bi ou en un alliage de ces métaux et présente une épaisseur inférieure à 10 nm et de préférence inférieure ou égale à 5 nm.

10. Elément magnétique selon une des revendications précédentes, **caractérisé en ce que** la première couche externe est en un oxyde diélectrique tel que SiOx, AlOx, MgOx, TiOx, TaOx, HfOx ou en un nitrure diélectrique tel que SiNx, BNx.

11. Elément magnétique selon une des revendications 1 à 9, **caractérisé en ce que** les deux couches externes sont conductrices et sont choisies en deux dits matériaux ou alliages non magnétiques différents.

12. Elément magnétique selon une des revendications précédentes, **caractérisé en ce que** la première couche externe (52) est recouverte d'une couche de lecture (58) en matériau magnétique et d'une électrode de lecture (59), **en ce que** la première couche externe (52) est en métal non-magnétique et **en ce qu'**elle forme avec la couche de lecture (58), l'électrode de lecture (59) et la couche centrale une vanne de spin.

13. Elément magnétique selon l'une des revendications 1 à 11, **caractérisé en ce que** la première couche externe (52) est recouverte d'une couche de lecture (58) en matériau magnétique et d'une électrode de lecture (59), **en ce que** la première couche externe (52) est diélectrique et **en ce qu'**elle forme avec la couche de lecture (58) l'électrode de lecture (59) et la couche centrale une jonction tunnel magnétique.

14. Elément magnétique selon une des revendications précédentes, **caractérisé en ce que** la première couche externe et la couche magnétique d'écriture forment un plot, alors que la deuxième couche externe forme une piste.

15. Elément magnétique selon la revendication 14, **caractérisé en ce que** le deuxième couche externe comporte une région en surépaisseur qui fait partie du plot.

16. Dispositif magnétique inscriptible, **caractérisé en ce qu'**il comporte une pluralité de plots selon une des revendications 14 ou 15 dont la deuxième couche externe comporte une dite piste qui leur est commune.

17. Dispositif magnétique inscriptible **caractérisé en ce que** la première couche externe, la couche magnétique d'écriture et la région en surépaisseur de la deuxième couche externe forment un plot selon la revendication 15 , et **en ce qu'**il comporte une pluralité desdits plots, ainsi qu'une piste électriquement conductrice bordant la deuxième couche externe desdits plots pour injecter ledit courant à travers la deuxième couche externe et la couche centrale de chacun desdits plots, la deuxième couche externe étant en un matériau électriquement conducteur différent de celui de la piste électriquement conductrice.

## Patentansprüche

1. Beschreibbares magnetisches Element, aufweisend einen Stapel von Schichten, davon eine magnetische Schreibschicht (13, 53, 70, 23, 63, 80) aus mindestens einem magnetischen Material, aufweisend eine Magnetisierungsrichtung parallel oder senkrecht zu ihrer Ebene sandwich-artig zwischen einer ersten (12, 52, 71, 22, 62) und einer zweiten (14, 54, 72, 24, 64, 82) äußeren Schichten angeordnet ist, die jeweils aus einem ersten und einem zweiten nichtmagnetischem Material zusammengesetzt sind, wobei
- das erste und das zweite nichtmagnetische Material unterschiedlich sind,
- das zweite nichtmagnetische Material leitend ist;
und
- eine Vorrichtung zum Anwenden eines Magnetfelds eine Komponente gemäß einer Richtung hat, die entweder parallel oder senkrecht zur Ebene der magnetischen Schreibschicht (13, 53, 70, 23, 63, 80) ist, so dass die Magnetisierungsrichtung und die Magnetfeldrichtung senkrecht zueinander sind;
wobei das Element **dadurch gekennzeichnet ist, dass** es aufweist:
- eine Vorrichtung, um einen Schreibstrom durch die zweite äußere Schicht und die magnetische Schreibschicht zu schicken, wobei dieser Schreibstrom in einer Stromrichtung parallel zur Ebene der magnetischen Schreibschicht zirkuliert und den Stapel nicht in einer Richtung senkrecht zur Ebene der Schichten durchquert,
wobei eine von der Vorrichtung angewendete Komponente der Richtung des Magnetfelds entweder parallel oder senkrecht zur Stromrichtung ist.

2. Magnetisches Element nach Anspruch 1, **dadurch gekennzeichnet, dass** das Magnetfeld entweder parallel oder senkrecht zur Ebene der magnetischen Schreibschicht und zur Stromrichtung ist.

3. Magnetisches Element nach einem der Ansprüche 1 oder 2, **dadurch gekennzeichnet, dass** die Magnetfeldrichtung parallel zur Stromrichtung ist und dass die Magnetisierungsrichtung senkrecht zur Ebene der magnetischen Schreibschicht (13, 53, 70) ist.

4. Magnetisches Element nach einem der Ansprüche 1 oder 2, **dadurch gekennzeichnet, dass** die Magnetisierungsrichtung parallel zur Stromrichtung ist und dass die Magnetfeldrichtung senkrecht zur Ebene der magnetischen Schreibschicht (23, 63, 80) ist.

5. Magnetisches Element nach einem der Ansprüche 3 oder 4, **dadurch gekennzeichnet, dass** die magnetische Schreibschicht (13, 23, 53, 63, 70, 80) eine Dicke zwischen 0,1 nm und 5 nm inklusive hat.

6. Magnetisches Element nach Anspruch 3, **dadurch gekennzeichnet, dass** die magnetische Schreibschicht (13, 53, 70, 23, 63, 80) eine Legierung aufweist, die eine eigene senkrechte magnetische Anisotropie aufweist, nämlich insbesondere FePt, FePd, CoPt, oder auch eine Legierung Seltene Erde/Übergangsmetall, insbesondere GdCo, TbFeCo.

7. Magnetisches Element nach Anspruch 3, **dadurch gekennzeichnet, dass** die magnetische Schreibschicht ein Metall oder eine Legierung aufweist, die im Stapel eine von den Schnittstellen induzierte senkrechte magnetische Anisotropie aufweist, insbesondere Co, Fe, CoFe, Ni, CoNi.

8. Magnetisches Element nach Anspruch 4, **dadurch gekennzeichnet, dass** die magnetische Schreibschicht ein Metall oder eine Legierung aufweist, die in dem Stapel eine planare magnetische Anisotropie aufweist, insbesondere Co, Fe, CoFe, Ni, NiFe, CoNi.

9. Magnetisches Element nach einem der vorangehenden Ansprüche, **dadurch gekennzeichnet, dass** mindestens eine äußere Schicht leitend ist, aus einem nichtmagnetischen Material wie Pt, W, Ir, Ru, Pd, Cu, Au, Bi oder aus einer Legierung dieser Metalle ist und eine Dicke unter 10 nm und vorzugsweise unter oder gleich 5 nm aufweist.

10. Magnetisches Element nach einem der vorangehenden Ansprüche, **dadurch gekennzeichnet, dass** die erste äußere Schicht aus einem dielektrischen Oxid wie SiOx, AlOx, MgOx, TiOx, TaOx, HfOx oder aus einem dielektrischen Nitrid wie SiNx, BNx ist.

11. Magnetisches Element nach einem der Ansprüche 1 bis 9, **dadurch gekennzeichnet, dass** die zwei äußeren Schichten leitend sind und aus zwei unterschiedlichen nichtmagnetischen Materialien oder Legierungen sind.

12. Magnetisches Element nach einem der vorangehenden Ansprüche, **dadurch gekennzeichnet, dass** die erste äußere Schicht (52) mit einer Leseschicht (58) aus magnetischem Material und einer Leseelektrode (59) bedeckt ist, dass die erste äußere Schicht (52) aus nichtmagnetischem Material ist und dass sie mit der Leseschicht (58), der Leselektrode (59) und der zentralen Schicht ein Spinventil bildet.

13. Magnetisches Element nach einem der Ansprüche 1 bis 11, **dadurch gekennzeichnet, dass** die erste äußere Schicht (52) mit einer Leseschicht (58) aus magnetischem Material und einer Leseelektrode (59) bedeckt ist, dass die erste äußere Schicht (52) dielektrisch ist und dass sie mit der Leseschicht (58), der Leselektrode (59) und der zentralen Schicht eine Magnettunnelverbindung bildet.

14. Magnetisches Element nach einem der vorangehenden Ansprüche, **dadurch gekennzeichnet, dass** die erste äußere Schicht und die magnetische Schreibschicht einen Stift bilden, wogegen die zweite äußere Schicht eine Piste bildet.

15. Magnetisches Element nach Anspruch 14, **dadurch gekennzeichnet, dass** die zweite äußere Schicht eine hervorgehobene Region aufweist, die Teil des Stifts ist.

16. Beschreibbare magnetische Vorrichtung, **dadurch gekennzeichnet, dass** sie eine Vielzahl von Stiften nach einem der Ansprüche 14 oder 15 aufweist, deren zweite äußere Schicht eine Piste aufweist, die ihnen gemeinsam ist.

17. Beschreibbare magnetische Vorrichtung, **dadurch gekennzeichnet, dass** die erste äußere Schicht, die magnetische Schreibschicht und die hervorgehobene Region der zweiten äußeren Schicht einen Stift nach Anspruch 15 bilden, und dass sie eine Vielzahl der Stifte aufweist, sowie eine elektrisch leitende Piste neben der zweiten äußeren Schicht der Stifte, um den Strom durch die zweiten äußere Schicht und die zentrale Schicht jedes der Stifte zu injizieren, wobei die zweite äußere Schicht aus einem elektrisch leitenden Material ist, das sich von dem der elektrisch leitenden Piste unterscheidet.

## Claims

1. Writable magnetic element comprising a stack of layers including a write magnetic layer (13, 53, 70, 23, 63, 80) of at least one magnetic material presenting a direction of magnetization that is parallel or perpendicular to its plane sandwiched between a first (12, 52, 71, 22, 62) and a second (14, 54, 72, 24, 64, 82) outer layers comprising respectively a first and a second non-magnetic material, where:
- the first and the second non-magnetic material are different;
- the second non-magnetic material is conductive;
and
- a device for applying a magnetic field having one component along a magnetic field direction that is either parallel or perpendicular to the plane of the write magnetic layer (13, 53, 70, 23, 63, 80), such that the direction of magnetization and the magnetic field direction are perpendicular to each other;
the element being **characterized in that** it comprises:
- a device for causing a write current to flow through the second outer layer and the write magnetic layer, this write current circulating in a current flow direction parallel to the plane of the write magnetic layer and not flowing through the stack in a direction that is perpendicular to the plane of the layers, the said component along the magnetic field direction applied by the device being either parallel or perpendicular to the current flow direction.

2. Magnetic element according to claim 1, **characterized in that** the magnetic field is either parallel or perpendicular to the plane of the write magnetic layer and to the current flow direction.

3. Magnetic element according to claim 1 or 2, **characterized in that** the magnetic field direction is parallel to the current flow direction and **in that** the direction of the magnetization is perpendicular to the plane of the write magnetic layer (13, 53, 70).

4. Magnetic element according to claim 1 or 2, **characterized in that** the direction of magnetization is parallel to the current flow direction and **in that** the magnetic field direction is perpendicular to the plane of the write magnetic layer (23, 63, 80).

5. Magnetic element according to claim 3 or 4, **characterized in that** the write magnetic layer (13, 23, 53, 63, 70, 80) has a thickness lying in the range 0.1 nm to 5 nm.

6. Magnetic element according to claim 3, **characterized in that** the write magnetic layer (13, 23, 53, 63, 70, 80) comprises an alloy presenting an intrinsic perpendicular magnetic anisotropy, i.e., in particular FePt, FePd, CoPt, or a rare earth / transition metal alloy, in particular GdCo, TdFeCo.

7. Magnetic element according to claim 3 , **characterized in that** the write magnetic layer comprises a metal or an alloy presenting in the stack a perpendicular magnetic anisotropy induced by the interfaces, in particular Co, Fe, CoFe, Ni, CoNi.

8. Magnetic element according to claim 4, **characterized in that** the write magnetic layer comprises a metal or an alloy presenting a planar magnetic anisotropy in the stack, in particular Co, Fe, CoFe, Ni, NiFe, CoNi.

9. Magnetic element according to any one of the preceding claims, **characterized in that** at least one outer layer is conductive, and is made of a non-magnetic metal such as Pt, W, Ir, Ru, Pd, Cu, Au, Bi, or of any alloy of these metals and has a thickness less than 10 nm and preferably less than or equal to 5 nm.

10. Magnetic element according to any one of the preceding claims, **characterized in that** the first outer layer is made of a dielectric oxide such as SiOₓ, AlOₓ, MgOₓ, TiOₓ, TaOₓ, HfOₓ, or of a dielectric nitride such as SiNₓ, BNₓ.

11. Magnetic element according to any one of claims 1 to 9, **characterized in that** both outer layers are conductive and are selected from two different ones of said non-magnetic materials or alloys.

12. Magnetic element according to any one of the preceding claims, **characterized in that** the first outer layer (52) is covered in a read layer (58) of magnetic material and in a read electrode (59), **in that** the first outer layer (52) is made of non-magnetic metal and **in that** it co-operates with the read layer (58), the read electrode (59), and the write magnetic layer to form a spin valve.

13. Magnetic element according to any one of claims 1 to 11, **characterized in that** the first outer layer (52) is covered in a read layer (58) of magnetic material and in a read electrode (59), **in that** the first outer layer (52) is dielectric and **in that** it co-operates with the read layer (58), the read electrode (59), and the write magnetic layer to form a magnetic tunnel junction.

14. Magnetic element according to any one of the preceding claims, **characterized in that** the first outer layer and the write magnetic layer form a stud, while the second outer layer forms a track.

15. Magnetic element according to claim 14, **characterized in that** the second outer layer includes a region of extra thickness forming part of the stud.

16. Writable magnetic device, **characterized in that** it comprises a plurality of studs according to any one of claims 14 or 15, with the second outer layer thereof including a said track that is common to the studs.

17. Writable magnetic device, **characterized in that** the first outer layer, the write magnetic layer, and the region of extra thickness of the second outer layer form a stud according to claim 15, and **in that** the device includes a plurality of said studs, together with an electrically conductive track beside the second outer layer of said stud to inject said current through the second outer layer and the central layer of each of said studs, the second outer layer being made of an electrically conductive material different from the material of the electrically conductive track.
